Europäisches Patentamt

European Patent Office

Office européen des brevets

(19)

(11) Numéro de publication : **0 469 506 B1**

(12) **FASCICULE DE BREVET EUROPEEN**

(45) Date de publication du fascicule du brevet :
30.08.95 Bulletin 95/35

(51) Int. Cl.⁶ : **H04B 5/00,** H01P 5/12, H03H 7/48

(21) Numéro de dépôt : **91112696.9**

(22) Date de dépôt : **29.07.91**

(54) **Dispositif de transmission radioélectrique à câbles rayonnants.**

(30) Priorité : **30.07.90 FR 9009683**

(43) Date de publication de la demande :
**05.02.92 Bulletin 92/06**

(45) Mention de la délivrance du brevet :
**30.08.95 Bulletin 95/35**

(84) Etats contractants désignés :
**CH DE DK FR GB LI**

(56) Documents cités :
**EP-A- 0 131 828
DE-B- 1 226 177
IRE TRANSACTIONS ON MICROWAVE
THEORY AND TECHNIQUES, vol. MTT-3, no. 2,
mars1955, pages 157-162, New York, US; D.J.
SOMMERS:** "Slot array employingphotoetched tri-plate transmission lines"

(73) Titulaire : **ALCATEL CABLE
30, rue des Chasses
F-92111 Clichy Cédex (FR)**

(72) Inventeur : **Devicque, Michel c/a ALCATEL
CABLE
30, rue des Chasses
F-92111 Clichy Cédex (FR)**
Inventeur : **Boby, Joel
5, impasse des Gazelles
F-93370 Montfermeil (FR)**

(74) Mandataire : **Weinmiller, Jürgen et al
Lennéstrasse 9
Postfach 24
D-82336 Feldafing (DE)**

EP 0 469 506 B1

# Description

La présente invention porte sur les systèmes de transmission radioélectrique utilisant des câbles rayonnants comme éléments de transmission de signaux haute fréquence entre un émetteur et un récepteur.

Les câbles rayonnants sont des câbles coaxiaux pourvus d'ouvertures calibrées sur leur gaine extérieure. Ces ouvertures confèrent aux câbles des propriétés de rayonnement radioélectrique, en produisant un champ radioélectrique haute fréquence au voisinage du câble, sur sa longueur. Le diagramme de rayonnement est quasi omnidirectionnel dans le plan transversal du câble. L'énergie rayonnée et l'énergie véhiculée sont dans un rapport quasi constant, lorsque le câble est à structure homogène, sur la longueur du câble.

Ces câbles rayonnants sont utilisés pour des transmissions bilatérales entre un dispositif émetteur et un dispositif récepteur, avec l'un de ces dispositifs fixe et l'autre mobile, sur un véhicule ou une personne par exemple. Ils sont utilisés notamment dans les tunnels, les galeries de mine, mais également le long de voies de chemin de fer ou de quais, ainsi que dans des zones à périmètre surveillé, pour une transmission de signaux convenables entre un dispositif émetteur-récepteur fixe et un dispositif récepteur-émetteur mobile.

Dans les dispositifs connus, le câble coaxial rayonnant est d'impédance caractéristique nominale Zo égale à celle des dispositifs émetteur et récepteur associés. Typiquement cette impédance caractéristique nominale Zo est de 50 ohms ou 75 ohms.

L'énergie véhiculée dans le câble et donc l'énergie rayonnée décroissent le long du câble à cause de l'affaiblissement linéïque, au fur et à mesure de l'accroissement de la distance de transmission depuis le dispositif émetteur. Pour un niveau d'émission donné, choisi pour un seuil maximal de réception fixé, et pour un seuil minimal de réception et un rapport signal/bruit également donnés, les limites de portée du câble dépendent essentiellement de sa caractéristique d'affaiblissement linéïque.

Pour l'augmentation de portée radioélectrique des dispositifs de transmission par câble rayonnant, une solution connue et utilisée consiste à adopter deux câbles rayonnants disposés symétriquement et alimentés au travers d'un coupleur 3 dB par un dispositif émetteur de niveau alors doublé. Le document EP-A- 0131 828 décrit une installation de transmission radioélectrique de ce type.

Cette configuration permet de doubler la portée radioélectrique, en conservant inchangés les seuils maximal et minimal de réception liés à la dynamique de fonctionnement des dispositifs récepteurs. Par contre, le coupleur 3 dB exige un réseau d'adaptation d'impédance relativement complexe, réalisé notamment par anneau hybride, lignes couplées en mode différentiel ou en mode commun, transformateur de Chebyshev, binominal, diviseur de puissance WILKINSON ou répartiteur 2 directions, pour une transmission bilatérale possible dans différentes bandes de fréquence. Il conduit à des pertes d'insertion importantes et/ou à une limitation des bandes passantes. Typiquement les bandes passantes obtenues sont de l'ordre d'une octave, de 450 à 900 MHz par exemple, pour éviter des pertes d'insertion trop importantes et donc inadmissibles.

On connaît également par le document DE-B-1226 177 une jonction en T assurant le couplage de deux lignes coaxiales dites transversales à une ligne coaxiale longitudinale. Cette jonction comporte des moyens d'adaptation d'impédance raccordant la ligne longitudinale aux lignes transversales, en ramenant l'impédance spécifique au point de raccordement à la valeur de l'impédance caractéristique nominale de cette ligne longitudinale.

Ces moyens d'adaptation d'impédance conduisent également à une limitation de bande passante.

La présente invention a pour but d'éviter ces inconvénients en permettant d'obtenir une transmission radioélectrique longue portée, avec une large bande passante ne dépendant essentiellement que des caractéristiques des câbles rayonnants et des dispositifs d'émission et réception, ainsi qu'un rendement énergétique amélioré.

Elle permet en outre une diminution du coût de réalisation du dispositif de transmission radioélectrique.

La présente invention a pour objet un dispositif de transmission radioélectrique par câbles coaxiaux rayonnants selon la revendication 1.

Selon une autre caractéristique ladite jonction en Té est équipée de connecteurs coaxiaux aux extrémités de ses branches.

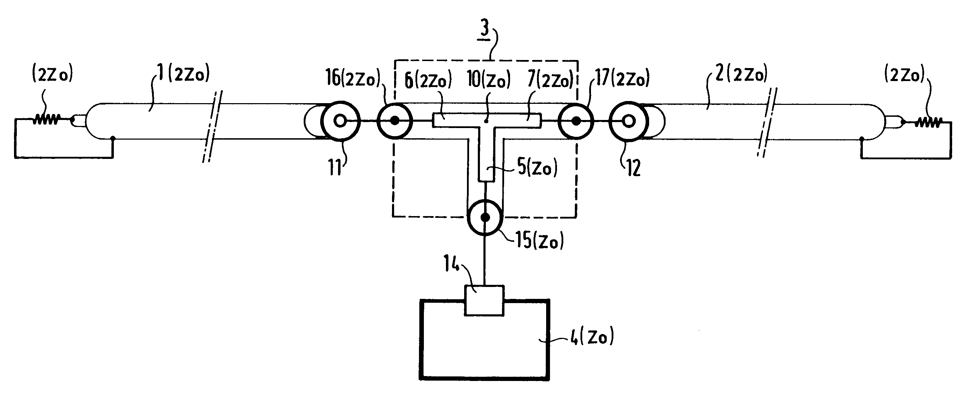

Les caractéristiques et avantages de la présente invention ressortiront clairement de la description faite ci-après d'un exemple de réalisation illustré dans la figure unique du dessin joint.

Cette figure unique montre schématiquement un dispositif de transmission radioélectrique selon la présente invention.

Le dispositif comporte deux câbles coaxiaux rayonnants 1 et 2 raccordés symétriquement à une jonction 3 elle même raccordée par ailleurs à un dispositif émetteur-récepteur 4.

Dans ce dispositif de transmission radioélectrique, l'un et l'autre des deux câbles coaxiaux 1 et 2 sont d'impédance caractéristique nominale notée 2Zo fixée à deux fois celle Zo du dispositif émetteur-récepteur 4. Leur impédance caractéristique nominale est de préférence de 100 ohms, avec Zo = 50 ohms.

La jonction 3 est quant à elle constituée par un premier tronçon de ligne coaxiale 5, d'impédance caractéristique nominale fixée à Zo, qui se divise, à l'une de ses extrémités en deux deuxièmes tronçons de ligne coaxiale, en parallèle, 6 et 7, chacun d'impédance caractéristique nominale fixée à 2Zo. Elle définit une jonction coaxiale en T. Le point de dérivation, noté 10, défini entre ce premier tronçon et les deux deuxièmes tronçons est d'impédance caractéristique Zo, répondant à l'équation fondamentale des circuits en parallèle :

$$\frac{1}{Z} = \frac{1}{2Zo} + \frac{1}{2Zo},$$

soit Z = Zo.

Les trois extrémités respectives de ces premier et deuxièmes tronçons de ligne sont pourvues chacune d'un connecteur coaxial 15, 16 ou 17 selon le tronçon considéré. Le connecteur 15 est d'impédance caractéristique Zo ; il permet le raccordement du tronçon de ligne 5 au dispositif émetteur-récepteur 4, par un connecteur coaxial complémentaire 14 de ce dispositif. Les connecteurs 16 et 17 sont l'un et l'autre d'impédance caractéristique 2Zo ; ils permettent le raccordement des deuxièmes tronçons de ligne 6 et 7 aux deux câbles rayonnants 1 et 2, respectivement, par un connecteur coaxial complémentaire 11 et 12 à l'une des extrémités de chaque tronçon.

Les deux câbles coaxiaux 1 et 2 ont par ailleurs leur autre extrémité fermée sur leur impédance caractéristique 2Zo, comme illustré.

La jonction 3 constitue un Té d'alimentation symétrique des deux câbles à partir du dispositif émetteur-récepteur raccordé à la branche transversale du Té.

Elle est réalisée par des microbandes conductrices formées sur des substrats diélectriques, les unes mises en sandwich entre deux substrats et raccordées en T et les autres sur les faces extérieures des substrats et mises à la masse. Les connecteurs de la jonction ont leur conducteur central relié à l'extrémité de la branche correspondante du Té et leur gaine extérieure aux microbandes mises à la masse.

Cette jonction peut également être réalisée par deux fentes cylindriques définissant un Té dans un bloc métallique mis à la masse. qui reçoivent chacun un conducteur axial, isolé du bloc et de diamètre calibré en fonction de celui de la fente concernée. Les conducteurs dans ces deux fentes sont raccordés l'un à l'autre à la jonction des fentes et raccordés au conducteur central des connecteurs individuels montés aux extrémités des fentes du Té.

Cette jonction 3 peut être réalisée en ayant de très petites dimensions, pour présenter des pertes d'insertion très faibles et quasi-négligeables. Les limites de fonctionnement du dispositif dépendent exclusivement des caractéristiques des câbles coaxiaux et des caractéristiques du dispositif émetteur-récepteur et de celui complémentaire récepteur-émetteur qui lui est couplé par l'un ou l'autre des câbles rayonnants. Le dispositif permet d'obtenir une bande passante très large, typiquement du continu à 3 GHz.

En outre, la jonction réalisée de petites dimensions est également de coût et d'encombrement inférieurs à ceux des coupleurs des dispositifs connus.

## Revendications

1. Dispositif de transmission radioélectrique par câbles coaxiaux rayonnants, comportant deux câbles coaxiaux rayonnants alimentés symétriquement par un dispositif émetteur-récepteur à travers un circuit de couplage, caractérisé en ce que lesdits câbles coaxiaux (1, 2) sont chacun une impédance caractéristique nominale 2Zo de valeur égale à deux fois celle Zo dudit dispositif émetteur-récepteur (4) et en ce que ledit circuit de couplage (3) est une jonction en Té (3) comprenant un premier tronçon de ligne coaxiale (5), d'impédance caractéristique nominale Zo égale à celle dudit dispositif émetteur-récepteur, et deux deuxièmes tronçons de ligne coaxiale (6, 7) en parallèle, chacune d'impédance caractéristique nominale 2Zo double de celle du premier tronçon, et ayant une première extrémité commune auxdits deuxièmes tronçons et reliée directement à une première extrémité du premier tronçon, en y définissant un point de dérivation (10), la deuxième extrémité dudit premier tronçon de ligne raccordée directement audit dispositif émetteur-récepteur, et les deuxièmes extrémités des deuxièmes tronçons de ligne raccordées directement à l'un et l'autre desdits câbles respectivement.

2. Dispositif selon la revendication 1, caractérisé en ce que ladite jonction (3) est équipée d'un premier connecteur coaxial (15), de même impédance que celle du premier tronçon, sur la deuxième extrémité dudit premier tronçon, et d'un deuxième connecteur coaxial (16, 17) de même impédance que celle de chacun des deuxièmes tronçons, sur la deuxième extrémité de chaque deuxième tronçon, et en ce que le dispositif émetteur-récepteur est lui équipé d'un connecteur (14) complémentaire dudit premier connecteur et chacun des deux câbles coaxiaux d'un autre connecteur (11, 12) complémentaire dudit deuxième connecteur (14).

3. Dispositif selon la revendication 2, caractérisé en ce que ladite jonction (3) est constituée par des premières microbandes conductrices formées sur un diélectrique et reliées les unes aux autres en T et par des deuxièmes microbandes conductrices également formées sur ledit substrat mais isolées des premières et mises à la masse.

4. Dispositif selon la revendication 2, caractérisé en ce que ladite jonction (3) est constituée par un bloc métallique mis à la masse et comportant deux fentes cylindriques se coupant selon un Té et deux conducteurs axiaux dans ces fentes, lesdits conducteurs étant isolés du bloc et raccordés l'un à l'autre à l'intersection desdites fentes.

## Patentansprüche

1. Vorrichtung zur Funkübertragung über zwei strahlende Koaxialkabel, welche von einer Sende-Empfangsvorrichtung über eine Koppelschaltung gespeist werden, dadurch gekennzeichnet, daß die Koaxialkabel (1, 2) jeweils einen Wellenwiderstand 2Zo aufweisen, der doppelt so groß wie der Wellenwiderstand Zo der Sende-Empfangsvorrichtung (4) ist, und daß die Koppelschaltung (3) ein T-Glied (3) ist, das ein erstes Koaxialleiterstück (5) mit einem Wellenwiderstand Zo entsprechend demjenigen der Sende-Empfangsvorrichtung und parallel dazu zwei zweite Koaxialleiterstücke (6, 7) aufweist, die je einen Wellenwiderstand 2Zo besitzen, der doppelt so groß wie der des ersten Stückes ist, und die ein gemeinsames erstes Ende aufweisen, das direkt an ein erstes Ende des ersten Leiterstücks angeschlossen ist, indem es dort einen Verzweigungspunkt (10) bildet, während das zweite Ende des ersten Leiterstücks direkt an die Sende-Empfangsvorrichtung angeschlossen ist und die zweiten Enden der zweiten Leiterstücke direkt an je eines der beiden Kabel angeschlossen sind.

2. Vorrichtung nach Anspruch 1, dadurch gekennzeichnet, daß das T-Glied (3) mit einem ersten koaxialen Steckverbinder (15) gleicher Impedanz wie derjenigen des ersten Leiterstücks am zweiten Ende des ersten Leiterstücks und mit je einem zweiten koaxialen Steckverbinder (16, 17) gleicher Impedanz wie derjenigen jedes der beiden Leiterstücke am zweiten Ende jedes zweiten Leitungsstücks ausgerüstet ist, und daß die Sende-Empfangsvorrichtung ihrerseits einen dem ersten Steckverbinder komplementären Steckverbinder (14) aufweist, während jedes der beiden Koaxialkabel einen weiteren, zum zweiten Steckverbinder (14) komplementären Verbinder (11, 12) aufweist.

3. Vorrichtung nach Anspruch 2, dadurch gekennzeichnet, daß das T-Glied (3) aus ersten leitenden Mikrobändern, die auf einem Dielektrikum gebildet und in Form eines T miteinander verbunden sind, und aus zwei leitenden Mikrobändern besteht, die ebenfalls auf dem Substrat gebildet, aber von den ersten Bändern isoliert und an Masse gelegt sind.

4. Vorrichtung nach Anspruch 2, dadurch gekennzeichnet, daß das T-Glied (3) aus einem Metallblock, der an Masse gelegt ist und zwei sich T-förmig schneidende zylindrische Schlitze umfaßt, sowie aus zwei axialen Leitern in diesen Schlitzen besteht, wobei die Leiter gegen den Block isoliert und im Schnittpunkt der beiden Schlitze aneinander angeschlossen sind.

## Claims

1. A device for radio transmission via radiating coaxial cables, the device comprising two radiating coaxial cables fed symmetrically from a transmitter/receiver equipment via a coupling circuit, the device being characterized in that said coaxial cables (1, 2) have a nominal characteristic impedance 2Zo which is fixed at twice the nominal characteristic impedance Zo of said transmitter/receiver equipment (4), and in that said coupling circuit (3) is a T-junction (3) comprising a first length of coaxial line (5) having a nominal characteristic impedance of Zo equal to that of said transmitter/receiver equipment and two second lengths of coaxial line (6, 7) in parallel, each having a nominal characteristic impedance of 2Zo, i.e. twice that of the first length, and having a first end common to said second lengths and connected directly to a first end of the first length, by defining a splitting point (10) thereon, the second end of said first length of line being connected to said transmitter/receiver equipment, and the second ends of the second lengths of line being directly connected to respective ones of said cables.

2. A device according to claim 1, characterized in that said junction (3) is fitted on the second end of said first length with a first coaxial connector (15), having the same impedance as the first length, and on the second end of each second length, with a second coaxial connector (16, 17) having the same impedance as each of the second lengths, and in that the transmitter/receiver equipment is fitted with a connector (14) complementary to said first connector, and each of the two coaxial cables is fitted with a respective other connector (11, 12) complementary to said second connector (14).

3. A device according to claim 2, characterized in that said junction (3) is made of conducting microstrips formed on a dielectric, connected to one another in a T-configuration via second conducting microstrips likewise formed on said substrate but isolated from the preceding strips and grounded.

4.  A device according to claim 2, characterized in that said junction (3) is constituted by a grounded metal block including two cylindrical bores defining a T-configuration, and by two axial conductors in said bores, the axial conductors being insulated from the block and being connected to each other at the junction between said bores.